(19) Europäisches Patentamt
European Patent Office
Office européen des brevets

(11) **EP 2 511 725 A1**

(12) **EUROPÄISCHE PATENTANMELDUNG**

(43) Veröffentlichungstag:
**17.10.2012 Patentblatt 2012/42**

(51) Int Cl.:
***G01R 33/483*** (2006.01)

(21) Anmeldenummer: **12163177.4**

(22) Anmeldetag: **04.04.2012**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **15.04.2011 DE 102011007501**

(71) Anmelder: **Universitätsklinikum Freiburg**
**79106 Freiburg (DE)**

(72) Erfinder:
 • **WEBER, Hans**
  **79106 Freiburg (DE)**

 • **ZAITSEV, Maxim**
  **79117 Freiburg (DE)**
 • **GALLICHAN, Daniel**
  **79106 Freiburg (DE)**
 • **HENNIG, Jürgen**
  **79100 Freiburg (DE)**

(74) Vertreter: **Kohler Schmid Möbus**
**Patentanwälte**
**Ruppmannstraße 27**
**70565 Stuttgart (DE)**

(54) **Verfahren der bildgebenden Magnetresonanz zur Selektion und Aufnahme von gekrümmten Schichten**

(57) Ein Verfahren der bildgebenden MR, wobei ein räumlich und zeitlich veränderliches Magnetfeld $B_{grad}$ eingesetzt wird, wobei $B_{grad}$ $n_{lin}$ Feldkomponenten mit einem räumlich linearen, sowie $n_{nonlin}$ Feldkomponenten mit einem räumlich nicht-linearen Verlauf aufweist, wobei das Senden des oder der HF-Pulse über ein HF-Sendesystem mit $n_S$ Sendespulen erfolgt, und wobei der Empfang über ein HF-Empfangssystem mit $n_E$ Empfangsspulen erfolgt, ist dadurch gekennzeichnet, dass das Magnetfeld $B_{grad}$ in wenigstens drei Magnetfeldausprägungen $B_{gradi}$ eingesetzt wird, dass $B_{grad1}$ einen räumlich nicht-linearen Verlauf hat, dass durch Anlegen von $B_{grad1}$ das Volumen mindestens einer gekrümmte Schicht selektiert wird, dass diese Schicht über die Amplitude und den räumlichen Verlauf von $B_{grad1}$, die Höhe des Frequenzoffsets und den zeitlichen Verlauf des oder der HF-Pulse gewählt wird, wobei die Schicht über ihre Mittelfläche $A_M$ beschrieben wird und ihre Dicke über die jeweilige Ausdehnung der Schicht entlang der Normalen der Mittelfläche $A_M$ definiert ist, dass sich das Volumen der selektierten Schicht aus $n_V$ Teilvolumen zusammensetzt, in denen jeweils die Gradienten von mindestens einem Paar der übrigen Magnetfeldausprägungen $B_{gradi}$ (i>1) zueinander und zur Normalen der Mittelfläche $A_M$ eine Winkelabhängigkeit von 70° bis 110° aufweisen, wobei mindestens eine Magnetfeldausprägung des jeweiligen Paares einen räumlich nicht-linearen Verlauf aufweist, und dass Kombinationen dieser Paare zur Ortskodierung verwendet werden. So können gekrümmte Schichten effizient und hochaufgelöst abgebildet werden und das Verfahren kann an die Schichtform angepasst werden.

Fig. 2

**Beschreibung**

Die Erfindung betrifft ein Verfahren der bildgebenden MR (=Magnetresonanz), wobei mit Hilfe eines Gradientensystems ein räumlich und zeitlich veränderliches Magnetfeld $B_{grad}$ zur räumlichen Selektion eines abzubildenden Bereiches und zur mindestens zweidimensionalen Ortskodierung der MR-Signale im abzubildenden Bereich eines zu untersuchenden Objektes eingesetzt wird, wobei das Magnetfeld $B_{grad}$ $n_{lin}$ Feldkomponenten mit einem räumlich linearen, sowie $n_{nonlin}$ Feldkomponenten mit einem räumlich nicht-linearen Verlauf aufweist, wobei $n_{lin} + n_{nonlin} \geq 1$ und $n_{lin}$, $n_{nonlin}$ $\varepsilon$ N, wobei die Amplitude und der räumliche Verlauf von $B_{grad}$ über die Stärke und das Verhältnis der Amplituden der einzelnen Feldkomponenten gesteuert wird, wobei das Senden des oder der HF-(=Hochfrequenz-) Pulse über ein HF-Sendesystem mit $n_s$ Sendespulen erfolgt, mit $n_s$ $\varepsilon$ N und $n_s \geq 1$, und wobei der Empfang des von dem zu untersuchenden Objekt gesendeten HF-Signals über ein HF-Empfangssystem mit $n_E$ Empfangsspulen erfolgt, mit $n_E$ $\varepsilon$ N und $n_E \geq 1$..

Teilaspekte eines solchen Verfahrens sind etwa aus [1] oder [2] bekannt.

Bei der bildgebenden Magnetresonanz handelt es sich um ein nicht-invasives Verfahren zur räumlichen Auflösung und Darstellung der inneren Struktur eines Objektes, wie zum Beispiel des menschlichen Körpers. Das Verfahren basiert auf dem energetischen Verhalten von Atomkernen in einem äußeren Magnetfeld, welches die Anregung der Kernspins durch geeignete HF (=Hochfrequenz)-Pulse erlaubt, sowie der anschließenden Auslesung der von den angeregten Kernspins ausgesendeten Signale.

Das empfangene MR-Signal setzt sich aus den einzelnen Signalen aller angeregten Spins zusammen. Eine räumliche Zuordnung dieser erfordert eine Kodierung der Positionen der Spins bereits während des Aufnahmeprozesses. Hierzu werden dem Hauptmagnetfeld $B_0$ räumlich veränderliche Magnetfeldausprägung $B_{gradi}$ (x,y,z) überlagert. Entsprechend Gleichung {1} führt dies zu einer ortsabhängigen Variation der Larmorfrequenz $v_L$ der Atomkerne, wobei B(x,y,z) die Magnitude des resultierenden Magnetfeldes und $\gamma$ das gyromagnetische Verhältnis bezeichnen:

$$\{1\}\ v_L(x,y,z) = B(x,y,z)/\gamma$$

Konventionell werden zur Ortskodierung Magnetfeldausprägungen mit einer räumlich möglichst linearen Änderung der Feldstärke verwendet, sogenannte lineare Gradienten. Zur Erzeugung dieser per Linearkombination stehen üblicherweise Gradientensysteme mit drei Feldkomponenten, deren lineare Gradienten entlang der x,y und z-Achse und somit orthogonal zueinander ausgerichtet sind, zur Verfügung. Die Ortskodierung in wahlweise ein, zwei oder drei Dimensionen erfolgt unter Variation der Amplitude der Gradienten entlang der entsprechenden Raumrichtungen gemäß den bekannten Prinzipien, etwa der Fourierkodierung, der gefilterten Rückprojektion oder einem anderen bekannten Verfahren [3].

Wird während der Einstrahlung des HF-Pulses eine Magnetfeldausprägung ($B_{grad1}$) angelegt, hat dies eine räumliche Begrenzung des angeregten Volumens zur Folge. In diesem als Schichtselektion bezeichneten Prozess werden nur diejenigen Kernspins angeregt, deren Larmorfrequenz $v_L$ innerhalb der Bandbreite des HF-Pulses liegt. Bei der Verwendung konventioneller linearer Schichtselektionsgradienten hat das selektierte Volumen die typische Form einer planaren Schicht. Diese ist über ihre ebene Mittelfläche $A_M$ mit

$$\{2\}\ B_{grad1}(A_M) = \gamma * Frequenzoffset$$

und ihre Dicke vollständig definiert, wobei sich letztere aus der Amplitude der Magnetfeldausprägung und der Bandbreite des HF-Pulses ergibt. Die Normale der Mittelfläche ist immer parallel zum linearen Gradienten der Magnetfeldausprägung $B_{grad1}$ ausgerichtet. Da diese per Linearkombination aus einem Satz von Feldkomponenten mit orthogonalen Gradienten erzeugt wird, ist durch entsprechende Komposition eine beliebige Orientierung und Positionierung der Schicht möglich. Die Orthogonalität der Gradienten ermöglicht ebenfalls die Erzeugung von weiteren Magnetfeldausprägungen $B_{gradi}$, deren Gradienten senkrecht zueinander und zur Mittelflächennormalen stehen, und gewährleistet folglich eine Ortskodierung entlang der Mittelfläche der angeregten Schicht. Diese entspricht einer standardmäßigen Projektion der Spindichte senkrecht zur Mittelfläche und damit verbunden einem rechtwinkligen Voxelvolumen.

Das für verschiedene Variationen von Magnetfeldausprägungen ausgelesene MR-Signal wird dem sogenannten k-Raum zugeordnet, wobei sich die Position im k-Raum aus der Stärke, Dauer und Orientierung der geschalteten Magnetfeldausprägungen ergibt. Welche k-Raum-Punkte in welcher Reihenfolge während einer Aufnahme abgetastet werden, wird durch die jeweilige Trajektorie des Aufnahmeverfahrens beschrieben. Allgemein werden in der Mitte des k-Raums die Signalanteile kodiert, welche die niederfrequenten Informationen enthalten und somit die grobe Struktur des abzubildenden Objektes beschreiben. Im Gegenzug dazu enthalten die Randbereiche die hochfrequenteren Detailinformationen. Die Größe des auch als FOV (=Field of View) bezeichneten Sichtfeldes des resultierenden MR-Bildes ist proportional zur Abtastdichte $1/\Delta k$ des k-Raumes. Bei einem zu kleinem FOV, welches das abzubildende Objekt nicht vollständig abdeckt, erscheinen die außenliegenden Bereiche des abzubildenden Objektes im rekonstruierten MR-Bild als nach innen gefaltet. Diese gefalteten Bildanteile werden als Aliasing bezeichnet.

Für eine eindimensionale Aufnahme muss lediglich eine Zeile im k-Raum aufgenommen werden. Die während der Aufnahme geschaltete Magnetfeldausprägung wird als Lesegradient bezeichnet. Die Auflösung einer MR-Aufnahme ist folglich für eine gegebene Abtastdichte durch die Stärke und Dauer des Lesegradienten bestimmt. Je steiler der Gradient und je länger er geschaltet ist, desto weiter von der k-Raum-Mitte entfernte Punkte können aufgezeichnet werden. Für eine zweidimensionale MR-Aufnahme werden mehrere k-Raum-Zeilen aufgenommen, wobei die Anzahl der Zeilen der Anzahl an Punkten in der zweiten Bilddimension entspricht. Die für die sogenannte Phasenkodierung zuständige Magnetfeldausprägung ("Phasengradient") wird hierbei für ein bestimmtes Zeitintervall zwischen der Anregung und der Aufnahme des Signals geschalten, wobei die Gradientenstärke für jede Zeile entsprechend variiert wird. Die Aufnahmedauer ergibt sich folglich aus dem Produkt der Anzahl an Zeilen und der Dauer TR (= Time of Repetition) für die Aufnahme einer Zeile. Im Falle einer dreidimensionalen MR-Aufnahme wird der k-Raum um eine dritte Dimension erweitert, für die Kodierung wird ein zusätzlicher Phasengradient entlang der entsprechenden Richtung geschaltet. Die Anzahl der k-Raum-Punkte entlang der jeweiligen Dimension und dementsprechend auch die Anzahl der resultierenden Bildpunkte werden durch die Matrixgröße beschrieben. Für eine Matrixgröße von $N_x \times N_y \times N_z$ und einer Zeilenaufnahmedauer TR ergibt sich für eine 3D Aufnahme folglich eine Messzeit TA (= Time of Acquisition) von

$$\{3\}\ TA(3D) = N_y \times N_z \times TR,$$

für eine 2D Aufnahme mit $N_x \times N_y$ Matrix entsprechend

$$\{4\}\ TA(2D) = N_y \times TR.$$

Im gewöhnlichen Fall eines äquidistant abgetasteten k-Raums erfolgt die Berechnung der Signaldichte im Frequenzraum direkt über die iFT (=inverse Fouriertransformierte) des k-Raum-Signales. Die anschließende Transformation der Signaldichte in den Ortsraum ergibt sich aus dem räumlichen Verlauf der jeweils zur Kodierung eingesetzten Magnetfeldausprägung.

Eine etablierte Möglichkeit die Aufnahmedauer zu reduzieren ist durch die Verwendung mehrerer Empfangsspulen und der damit verbundenen Ortsinformationen gegeben [4]. Bei der parallelen Bildgebungstechnik SENSE [5, 6], werden während der Aufnahme k-Raum-Zeilen gezielt ausgelassen. Die Aufnahmedauer wird dadurch verkürzt, man spricht hier von einer Beschleunigung. Die aus den aufgenommenen Daten der einzelnen Spulen rekonstruierten MR-Bilder sind bedingt durch die reduzierte Abtastdichte jedoch gefaltet. Auf Grund der räumlich unterschiedlich variierenden Sensitivität der einzelnen Empfangsspulen, mit welcher das empfangene Signal jeweils moduliert wird, kommt es in jedem Spulenbild zu einer unterschiedlichen Gewichtung zwischen der Intensität des Bildes und der des faltungsbedingten Aliasing. Sind die Sensitivitätsverteilungen der einzelnen Spulen bekannt, kann das Aliasing durch Lösung eines entsprechenden Gleichungssystems beschrieben und dementsprechend aus dem aus allen Spulendaten resultierenden Gesamtbild heraus gerechnet werden. Eine weitere parallele Bildgebungstechnik ist als GRAPPA [7, 8]. Im Gegensatz zu SENSE werden hier aus den zusätzlichen Spuleninformationen die fehlenden k-Raum-Zeilen vor der Rekonstruktion des MR-Bildes berechnet.

Standardmäßige MR-Bildgebung erfolgt unter Verwendung von rein linearen Gradientensystemen und erlaubt die Abbildung von dünnen Schichten mit beliebiger Orientierung und einer rechtwinkligen Voxelform. Bedingt durch die Linearität der Gradienten ist sie jedoch auf die Selektion und Kodierung von planaren Schichten beschränkt. Gerade aber organische Strukturen wie sie beispielsweise der Spinalkanal oder die Oberfläche eines Gehirns, lassen sich nicht durch eine planare Schicht beschreiben. Eine vollständige Abdeckung solcher Strukturen erfordert daher die Selektion einer dicken Schicht, verbunden mit einer zeitaufwendigen dreidimensionaler Kodierung oder die Aufnahme von mehreren Ebenen, sowie die anschließende Reformatierung der einzelnen Schichten. Die Selektion und Kodierung einer gekrümmten Schicht, deren Form an die Struktur des zu untersuchenden Objektes angepasst werden kann, ist daher wünschenswert.

Bereits 1989 haben Lee und Cho [9] mittels einer Magnetfeldausprägung der Form $B_{grad1}=x^2+y^2-2z^2$ gezeigt, dass die Verwendung einer Magnetfeldausprägung mit einem räumlich nicht-linearen Verlauf als Schichtselektionsgradient die Selektion eines von der Form einer planaren Schicht abweichenden Volumens erlaubt. Bei diesem zur zweidimensionalen Beschränkung des Selektionsvolumens entwickelten Verfahrens wurde das angeregte, zylindrische Volumen anschließend durch eine zeitaufwendige lineare 3D Kodierung räumlich aufgelöst. Oh und Kollegen [1] haben diese Technik um das Anlegen eines zusätzlichen linearen Gradienten während der Einstrahlung eines HF-Refokusierungspulses erweitert, so dass das die 3D Kodierung des zylindrischen Volumen auf die 2D Kodierung einer planaren, kreisförmigen Schicht reduziert werden konnte. In weiterführenden Arbeiten haben sie [10], sowie Wu und Kollegen [11] ebenfalls demonstriert, dass das Selektionsvolumen durch zusätzliche Verwendung von Magnetfeldkomponenten mit einem räumlich linearen Verlauf während des Selektionsprozesses räumlich verschoben, sowie dass die Form des Selektionsvolumens durch Variation des Frequenzoffsets des HF-Pulses verändert werden kann. Diese früheren Methoden zielen explizit auf die Selektion einer zwar räumlich beschränkten, jedoch planaren Schicht ab.

Als Alternative zur Wahl des Selektionsvolumens über den räumlichen Verlauf des Schichtselektionsgradienten haben Börnert und Schäffter 1996 [12, 13] demonstriert, dass mittels mehrdimensionalen HF-Pulsen der Selektionsprozess räumlich begrenzt werden kann. Explizit wird hierbei auch die Selektion von gekrümmten Schichten, deren Position, Orientierung und Krümmung mit sehr hoher Flexibilität gewählt werden kann, gezeigt. Die räumlich selektive Anregung mittels mehrdimensionaler HF-Pulse basiert auf der Einstrahlung eines HF-Pulses mit einem an die Form des zu selektierenden Volumens angepassten zeitlichen Verlauf in Kombination mit einer zeitlichen und räumlichen Variation der Amplitude und Orientierung der Magnetfeldausprägung $B_{grad1}$. Die Reihenfolge der Schaltung, inklusive der Stärke, Dauer und Orientierung der Magnetfeldausprägung $B_{grad1}$, wird analog der Schaltung der Magnetfeldausprägungen zur Ortskodierung durch eine entsprechende Trajektorie im (Sende-)k-Raum beschrieben. Die räumliche Ausdehnung des Bereiches in dem sich das zu selektierende Volumen befinden soll ist auch hier proportional zur Abtastdichte, die Auflösung des Zielmusters des zu selektierenden Volumens außerdem zur Anzahl der Abtastpunkte des Sende-k-Raums. Für eine zusätzliche selektive Anregung entlang der dritten Dimension muss der Sende-k-Raum entsprechend erweitert werden. Da die gesamte Trajektorie während des einmaligen Sendens des HF-Pulses abgetastet wird, ist die Auflösung des Zielmusters durch die zur Verfügung stehende Stärke und Schaltrate der Magnetfeldausprägung $B_{grad1}$, sowie die Dephasierungsgeschwindigkeit des bereits angeregten Signals, in der Regel stark begrenzt. Die im Vergleich zu konventionellen, eindimensionalen HF-Pulsen immer noch längere Dauer der mehrdimensionalen HF-Pulse erhöht die minimal mögliche Echozeit der Aufnahmen. Ebenfalls resultiert sie in einer erhöhten Sensitivität gegenüber Inhomogenitäten des statischen Magnetfelds, welche sich vor allem in einer inhomogenen Anregung und Artefakten äußert. Hinzu kommt, dass der mit der Dimension steigende Energiebedarf von HF-Pulsen bereits bei zweidimensionalen HF-Pulsen zu einer stark erhöhten Energiedeposition im zu untersuchenden Objekt führt. SAR (Spezifische Absorptions Rate) Grenzwerte spielen daher eine limitierende Rolle bei der Wahl der Puls- und somit der Schichtform. Die Selektion mittels mehrdimensionaler HF-Pulse ist daher deutlich komplexer als mit konventionellen, eindimensionalen Pulsen, ihre Anwendung in der Praxis teils stark eingeschränkt.

In ihrer Arbeit haben Börnert und Schäffter ebenfalls die Problematik der Ortskodierung einer gekrümmten Schicht demonstriert. Eine konventionelle Kodierung mit linearen Gradienten entspricht einer Projektion der nicht-planaren Schicht auf eine planare Fläche. Das Orthogonalitätskriterium, welches besagt dass Kodierungsgradienten und Flächennormale senkrecht zueinander stehen, kann daher nur in wenigen Bereichen erfüllt werden. Je stärker die Mittelflächennormale der angeregten Schicht hiervon abweicht, desto stärker verzerrt ist die Form der resultierenden Voxel. Dies geht einher mit einer Reduzierung der lokalen Auflösung bis hin zu Mehrdeutigkeiten, wenn die Spindichte unterschiedlicher Bereiche räumlich zusammenfallen. Dies ist beispielsweise der Fall bei einer Projektion einer mit einem Radius größer als 90° gekrümmten Schicht auf eine Ebene. Um die bei der Projektion überlagerten Bereiche dennoch voneinander trennen zu können, schlagen Börnert und Schäffter [13] eine zusätzliche HF-Kodierung der entsprechenden Bereiche vor. In einer Weiterentwicklung dieses Verfahrens mit verfeinerten Bereichen zeigt Börnert [14] die Annäherung einer entlang einer Schichtdimension gekrümmten Schicht durch eine Aneinanderreihung von N rechtwinkligen Voxeln gleicher Orientierung. Die Kodierung entlang der Voxelkette erfolgt durch N-fache Anregung der Voxelkette, wobei durch entsprechende Anpassung des 2D HF-Pufses auch die Phase entlang der Voxelkette variiert wird. Mittels bekannter Prinzipien, wie beispielsweise der Fouriertransformation ist anschließend eine Trennung der Voxel wieder möglich. Das Verfahren reduziert somit die Zweidimensionaütät der Rekonstruktion auf eine Dimension. Nachteilig ist dabei, dass, gemäß der Natur des Verfahrens, bei der HF-Pulskodierung einer gekrümmten Schicht ebenfalls die typischen Probleme bei Verwendung mehrdimensionaler Pulse wie zum Beispiel eine hohe Sensitivität gegenüber Inhomogenitäten des statischen Magnetfelds oder eine erhöhte Energiedeposition im zu untersuchenden Objekt auftreten. Hinzu kommt, dass auf Grund der mehrfachen Einstrahlung von komplexen HF-Pulsen das Verfahren ebenfalls anfällig gegenüber individuellen Störungen der Pulse ist. Daraus resultierende Unregelmäßigkeiten in der Kodierung entlang der Voxelkette führen beispielsweise zu Intensitätsmodulationen oder Störsignalen. Auch wenn dass Verfahren theoretisch zur Kodierung entlang beider Schichtdimensionen einer gekrümmten Schicht angewandt werden kann, ist es in der Praxis auf eine gekrümmte Dimension begrenzt: neben der bereits erwähnten Problematik von 3D HF-Pulsen würde die Kodierung eines N x N "Voxelteppichs" eine N-fache Erhöhung der Aufnahmedauer zur Folge haben. Hinzu kommt, dass die Voxel zwar eine rechtwinklige Form aufweisen aber mit ihren Seitenflächen in der Regel nicht entlang der Mittelfläche ausgerichtet sind. Besonders die bereits erwähnte Problematik der reduzierten lokalen Auflösung bleibt erhalten. Eine Kodierung entlang einer gekrümmten Schicht im Sinne einer Projektion der Spindichte senkrecht zu deren Mittelfläche ist daher mit diesem Verfahren nicht möglich.

Ein alternativer Ansatz zur Kodierung einer mittels 2D HF-Pulsen selektierten und entlang einer Schichtdimension gekrümmten Schicht wurde durch Jochimsen und Kollegen [15] vorgeschlagen. Bei ihrem Verfahren nähern sie die gekrümmte Mittelfläche der Schicht durch mehrere Ebenen an. Jeder dieser Ebenen wiederum kann eine Ebene im dreidimensionalen k-Raum zugeordnet werden. Unter Beachtung der auflösungsbedingten Abtastdichte werden dadurch die aufzunehmenden k-Raum Punkte definiert. Die Rekonstruktion entlang der gekrümmten Schicht erfolgt mittels numerischer Fourier Integration. Nachteilig an diesem Verfahren sind vor allem die Anforderungen an die Schichtform: diese darf nur entlang einer Dimension gekrümmt sein, ebenso muss die Krümmung durch einen Polygonzug angenähert werden können. Ferner setzt das Verfahren voraus, dass für jeden Punkt der Schicht der Kontrast entlang der Mittelflächennormalen konstant ist, da es ansonsten zu Interferenzen zwischen den einzelnen Ebenen kommen kann. Hinzu kommt, dass zur Vermeidung von Aliasing jede Ebene vollständig abgetastet werden muss. Auf Grund der Überlagerung der einzelnen Segmente werden somit mehr Punkte aufgenommen als zur Rekonstruktion der eigentlichen, gekrümmten Schicht, notwendig wären. Der Grad der Ineffizienz steigt hierbei mit der Anzahl an Segmenten. In der Praxis kann somit mit diesem Verfahren lediglich eine Kodierung entlang der gekrümmten Schicht grob angenähert werden.

Aufgabe der Erfindung

Der Erfindung liegt daher die Aufgabe zugrunde, ein bildgebendes MR-Verfahren zur Verfügung zu stellen, mit dem gekrümmte Schichten effizient und hochaufgelöst abgebildet werden können. Das Verfahren soll an die jeweilige Schichtform angepasst werden können.

Kurze Beschreibung der Erfindung

Diese Aufgabe wird erfindungsgemäß auf überraschend einfache wie wirkungsvolle Weise dadurch gelöst, dass das Magnetfeld $B_{grad}$ während eines einzelnen Messzyklus vom Anregen bis zum Auslesen der MR-Signale in wenigstens drei Magnetfeldausprägungen $B_{gradi}$ im abzubildenden Bereich des zu untersuchenden Objektes eingesetzt wird, dass die erste Magnetfeldausprägung $B_{grad1}$ einen räumlich nicht-linearen Verlauf hat, dass durch Anlegen der ersten Magnetfeldausprägung $B_{grad1}$ während der Einstrahlung eines oder mehrerer HF-Pulse das Volumen mindestens einer gekrümmte Schicht selektiert wird, dass die Position und Orientierung der gekrümmten Schicht, der Grad der Krümmung und die Dicke der Schicht über die Amplitude und den räumlichen Verlauf der ersten Magnetfeldausprägung $B_{grad1}$, der Höhe des Frequenzoffsets und des zeitlichen Verlaufs des oder der HF-Pulse gewählt werden, wobei die Position, Orientierung und Krümmung der Schicht über ihre Mittelfläche AM mit $B_{grad1}(A_M)$= gyromagnetisches Verhältnis y*Frequenzoffset beschrieben wird und ihre Dicke über die jeweilige Ausdehnung der Schicht entlang der Normalen der Mittelfläche $A_M$ definiert ist, dass sich das Volumen der selektierten Schicht aus $n_V$ Teilvolumen zusammensetzt, dass in jedem Teilvolumen die Gradienten von mindestens einem Paar der übrigen Magnetfeldausprägungen $B_{gradi}$ (i>1) zueinander und zur Normalen der Mittelfläche AM innerhalb des Teilvolumens eine Winkelabhängigkeit von 70° bis 110° aufweisen, wobei mindestens eine Magnetfeldausprägung des jeweiligen Magnetfeldausprägungspaares einen räumlich nicht-linearen Verlauf aufweist, und dass Kombinationen dieser Paare zur mindestens zweidimensionalen Ortskodierung des MR-Signals entlang der Mittelfläche $A_M$ der selektierten Schicht verwendet werden.

Die Erfindung beruht auf dem Prinzip, dass durch lineare Kombination von räumlich linearen und nicht-linearen Feldkomponenten ein Satz von mindestens drei Magnetfeldausprägung $B_{gradi}$ so erzeugt wird, dass durch Schalten der ersten Magnetfeldausprägung $B_{grad1}$ in Kombination mit einem oder mehreren HF-Puls eine Schicht mit gewünschter Position, Orientierung und Krümmung selektiert wird und dass für jedes Teilvolumen der selektierten Schicht mindestens ein Paar von Magnetfeldausprägungen $B_{gradi}$ (i>1) existiert, deren Gradienten zueinander und zur Normalen der Mittelfläche AM annähernd senkrecht, d.h. im Bereich 70° bis 110°, ausgerichtet sind, so dass durch die anschließende Ortskodierung mit diesen Magnetfeldausprägungspaaren eine Projektion der Spindichte innerhalb jedes Teilvolumens annähernd senkrecht zur Mittelfläche erfolgt.

Die mit der Erfindung erzielten Vorteile bestehen insbesondere darin, dass zum einem durch die Magnetfeldausprägung $B_{gradi1}$ auf schnelle und effiziente Weise eine gekrümmte Schicht selektiert wird und zum anderen durch die gezielte Kombination der weiteren Magnetfeldausprägungen $B_{gradi}$ (i>1) eine tatsächliche Ortskodierung entlang beider Dimensionen der Mittelfläche erfolgt. Analog einer konventionellen Mehrschichtselektion können mit dem erfindungsgemäßen Verfahren ebenfalls Pakete mit mehreren gekrümmten Schichten selektiert werden, wobei die einzelnen Schichten sich nicht überlappen. In der vorliegenden Beschreibung wird jedoch aus Gründen der Übersichtlichkeit exemplarisch immer nur von der Selektion einer Schicht ausgegangen. Die durch die erfindungsgemäße Ortskodierung bedingte annähernd senkrechte (70° bis 110°) Projektion der Spindichte auf die Mittelfläche resultiert in Voxeln mit einer annähernd rechtwinkligen Form und einer Ausrichtung entlang der Mittelfläche. Die lokale Ortsauflösung ist dadurch optimiert. Besonders hervorzuheben ist, dass hierdurch auch Mehrdeutigkeiten, wie sie beispielsweise im Falle der Projektion einer mit einem Radius größer gleich 90° gekrümmten Schicht auf eine Ebene auftreten, vermieden werden. Ferner entspricht eine annähernd rechtwinklige Voxelform dem Stand konventioneller MR-Aufnahmen, in deren Interpretation die Nutzer bereits geübt sind. Ebenfalls können durch die annähernd senkrechte Projektion der Spindichte auf die Mittelfläche im gesamten abzubildenden Bereich der angeregten Schicht partielle Volumeneffekte reduziert werden.

Die Zusammensetzung der Magnetfeldausprägungen $B_{gradi}$ aus einzelnen Feldkomponenten und die dadurch bedingte Möglichkeit zur Variation ihres räumlichen Verlaufs resultiert ebenfalls in einer hohen Flexibilität bei der Wahl der Position, Orientierung und Krümmung der zu selektierenden Schicht entlang beider Schichtdimensionen. Gegenüber dem Standardverfahren der Selektion einer gekrümmten Schicht mittels mehrdimensionalen HF-Pulsen gibt es keine Auflösungsbeschränkung, das angeregte Volumen zeichnet sich durch einen glatten Verlauf aus. Ebenfalls können kürzere und einfachere eindimensionale HF-Pulse verwendet werden. Hierdurch werden nicht nur kürzere Echozeiten erzielt, auch ist der Selektionsprozess weniger sensitiv gegenüber $B_0$-Inhomogenitäten, resultierend in einer homogeneren Anregung des Volumens mit weniger Artefakten. Die Verwendung von konventionellen, eindimensionalen HF-Pulsen erfordert ebenfalls eine niedrigere Sendeleistung, so dass die Energiedeposition im zu untersuchenden Objekt gegenüber dem Standardverfahren stark reduziert ist. Eine Begrenzung bei der Wahl der Schichtform durch SAR Grenzwerte ist folglich vernachlässigbar. Ein weiterer Vorteil des erfindungsgemäßen Verfahrens ist, dass zum Beispiel für den einfachen Fall mit $n_V=1$ Teilvolumen die Magnetfeldausprägungen $B_{gradi}$, bzw. die Kombinationen dieser, direkt einem Schichtselektions-, Lese-, und Phasengradient zugeordnet werden können. Somit können konventioneller Sequenzen ohne aufwändige Änderungen direkt auf das erfindungsgemäße Verfahren übertragen werden. Dies gilt ebenfalls für die Schaltung zusätzlicher Gradienten, wie beispielsweise Schichtrefokusierungs-, Spoiler- oder Dephasierungsgradienten.

Konventionelle Schichtselektion durch Anlegen einer Magnetfeldausprägung mit einem räumlich linearen Verlauf während der Einstrahlung eines einfachen HF-Pulses (z. B. sinc-Puls) ist ein schnelles und effizientes Verfahren zur Selektion einer dünnen oder auch dicken, planaren Schicht. Die Erweiterung dieses Verfahrens durch Anlegen einer ersten Magnetfeldausprägung $B_{grad1}$ mit einem räumlich nicht-linearen Verlauf ermöglicht die Selektion einer nicht-planaren Schicht, beziehungsweise eines gekrümmten Volumens bei Beibehaltung der Schnelligkeit und Effizienz dieses Verfahrens. Wird zudem die Magnetfeldausprägung $B_{grad1}$ als Linearkombination aus Feldkomponenten mit räumlich linearen und räumlich nicht-linearen Verläufen erzeugt, kann der räumliche Verlauf von $B_{grad1}$ über die Amplituden der einzelnen Feldkomponenten gezielt angepasst werden. In Kombination mit einer entsprechenden Anpassung der Bandbreite und des Frequenzoffsets des oder der HF-Pulse ist es somit möglich, die Position, Orientierung aber auch die Krümmung der nicht-planaren Schicht im hohen Maße frei zu wählen. Um die Spindichte im abzubildenden Bereich des zu untersuchenden Objektes auf die Mittelfläche der selektierten, nicht-planaren Schicht abzubilden, werden entsprechend dem erfindungsgemäßen Verfahren Kombinationen von Paaren weiterer Magnetfeldausprägungen $B_{gradi}$ (i>1) zur Ortskodierung eingesetzt. Diese sind hierbei so gewählt, dass im gesamten abzubildenden Bereich ($n_V=1$) die Gradienten von mindestens einem Paar zueinander und zur Normalen der Mittelfläche annähernd senkrecht ausgerichtet sind. Für den Fall, dass der erforderliche räumliche Verlauf der Magnetfeldausprägungen aus physikalischen oder hardwaretechnischen Gründen nicht realisiert werden kann, erfolgt die Aufteilung des Schichtvolumens in $n_V>1$ Teilvolumina. Anzahl und Form werden hierbei so gewählt, so dass in jedem Teilvolumen mindestens ein Magnetfeldausprägungspaar vorhanden ist, deren Gradienten annähernd das Orthogonalitätskriterium bezüglich der Normalen der Mittelfläche erfüllen. Hierdurch wird erzielt, dass in jedem Teilvolumen die angeregte Spindichte auf die Mittelfläche der nicht-planaren Schicht projiziert und somit - nach Anwendung eines entsprechenden Rekonstruktionsverfahrens - Voxel mit einer annähernd rechtwinklige Form und einer Ausrichtung entlang der Mittelfläche erzielt werden. Das erfindungsgemäße Verfahren transformiert somit erfolgreich das aus der linearen Bildgebung bewährte Prinzip, bei welchem zur Schichtselektion und anschließenden Ortskodierung orthogonale Gradientenfelder verwendet werden, auf die nicht-lineare Bildgebung.

Bevorzugte Varianten der Erfindung

Bei einer bevorzugten Variante des erfindungsgemäßen Verfahrens erfolgt unter Verwendung der ersten Magnetfeldausprägung $B_{grad1}$ eine zusätzliche Ortskodierung der selektierten Schicht jeweils entlang einer Achse, welche lokal im Bereich -20° bis 20° zur Normalen der Mittelfläche AM ausgerichtet ist. Durch diese zusätzliche Ortskodierung annähernd senkrecht zur Mittelfläche wird die angeregte Schicht dreidimensional kodiert, so dass eine Aufteilung der Schicht in entsprechende Unterschichten erzielt wird. Diese zeichnen sich dadurch aus, dass sie trotz ihrer Krümmung nahtlos aneinandergereiht sind und somit das angeregte Schichtvolumen unter Beibehaltung einer lokal annähernd rechtwinkligen Voxelform vollständig und ohne Überlappung abbilden. Diese Variante des erfindungsgemäßen Verfahrens erlaubt es ebenfalls, besonders dünne Schichten des zu untersuchenden Objektes darzustellen.

Eine andere bevorzugte Variante des erfindungsgemäßen Verfahrens ist dadurch gekennzeichnet, dass die erste Magnetfeldausprägung $B_{grad1}$ während der Einstrahlung des oder eines oder mehrerer der HF-Pulse zeitlich und räumlich variiert wird. Hierdurch ist es möglich, durch Kombination mit einem oder mehreren entsprechend angepassten HF-Pulsen, eine nicht-planare Schicht anzuregen, deren Form von der durch ein konstantes $B_{grad1}$ gegebenen Schicht abweicht. So können beispielsweise der räumliche Verlauf der Krümmung oder die räumliche Variation der Schichtdicke geändert werden.

Eine ebenfalls besondere Variante des erfindungsgemäßen Verfahrens ist dadurch gekennzeichnet, dass die Magnetisierung der selektierten Schicht durch eine oder mehrere Anregungen, Refokusierungen und oder Sättigungen vorbereitet wird, wobei bei wenigstens einem HF-Puls die nicht-lineare erste Magnetfeldausprägung $B_{grad1}$ verwendet wird. Die Anwendung von Kombination dieser bekannten Techniken der Magnetisierungspräperation erhöht unter anderem die Flexibilität bei der Wahl der Volumenselektion.

Im Rahmen der vorliegenden Erfindung fällt auch eine Variante des erfindungsgemäßen Verfahrens, bei welcher der zeitliche Verlauf der Amplitude und Phase des oder eines oder mehrerer der HF-Pulse für jede der $n_s$ Sendespulen angepasst wird. Basierend auf der unterschiedlichen Position und räumlich variierenden Sensitivität der $n_s$ Sendespulen erlaubt diese Variante die gezielte Regulierung des oder der HF-Pulse in einem bestimmten Volumenbereich. So ist es zum Beispiel möglich, die Anregung einer Schicht gezielt auf einen Volumenbereich zu begrenzen. Gerade bei Verwendung von Magnetfeldausprägungen welche in der Selektion von mehreren, doppeldeutigen Schichten resultieren, erhöht dieses Variante die Flexibilität bei der Schichtpositionierung. Im Rahmen der Anwendung mehrdimensionaler HF-Pulse erlaubt diese Verwendungsvariante auch eine Unterabtastung des Sende-k-Raums. Dies erlaubt beispielsweise die Verwendung kürzerer HF-Pulse oder eine höhere Auflösung des zu selektierenden Volumens.

Eine andere bevorzugte Variante des erfindungsgemäßen Verfahrens ist dadurch gekennzeichnet, dass während des Signalempfangs die lokale Gewichtung und Position der $n_E$ Empfangsspulen berücksichtigt wird und die Unterschiede zwischen den einzelnen Empfangsspulen für die Rekonstruktion des Bildes verwendet werden. Diese Verwendungsvariante erlaubt zusätzlich die Rekonstruktion von MR-Signalen, zu deren Ortskodierung mehrdeutige Kodierfelder verwendet wurden. Die Spindichte gleich kodierter Orte wird hierbei auf Basis der Unterschiede zwischen den Signalen der einzelnen Empfangsspulen und deren bekannten Sensitivitätsverteilungen voneinander getrennt und jeweils dem richtigen Ort zugeordnet. In der technischen Implementierung wird hierbei die Inverse der Kodiermatrix mittels Verfahren wie beispielsweise der Matrixinversion berechnet. Die Bandbreite an verwendbaren Magnetfeldausprägungen und die damit verbundene Auswahl an Schichtformen werden somit erweitert. Im Falle von mehreren, doppeldeutigen Schichten, welche so positioniert sind, das beide Teile des zu untersuchenden Objektes anregen, kann dieses Verfahren ebenfalls zur Zuordnung der Spindichte zu der jeweiligen Schicht angewandt werden. Dies erhöht wiederum die Flexibilität bei der Schichtpositionierung.

Die Berücksichtigung dieser zusätzlichen Kodierungsinformationen ermöglicht ebenfalls die Verwendung von unterabgetasteten Daten und somit eine Beschleunigung des Aufnahmeprozesses, da folglich weniger Datenpunkte aufgenommen werden müssen. Eine Unterabtastung der Daten hat eine Einfaltung des Bildes zur Folge, verschiedene Bereiche werden überlagert. Die Verwendung der unterschiedlichen Signale aus den einzelnen Empfangsspulen beispielsweise im Rahmen eines SENSE oder GRAPPA Rekonstruktionsverfahrens erlaubt hierbei eine Trennung der überlagerten Bereiche. Eine andere Variante des erfindungsgemäßen Verfahrens sieht vor, dass eine der zur räumlichen Kodierung im jeweiligen Teilvolumen zugewiesenen Magnetfeldausprägungen zur Frequenzkodierung und eine andere zur Phasenkodierung verwendet werden. Im Falle von $n_V=1$ wären dies zum Beispiel $B_{grad2}$ und $B_{grad3}$. Diese Zuordnung erlaubt unter anderem die Verwendung von Standardsequenzen der zweidimensionalen Bildgebung wie beispielsweise RARE, EPI oder FLASH, welche eine Magnetfeldausprägung zur Frequenz- und eine Magnetfeldausprägung zur Phasenkodierung verwenden.

Alternativ dazu sieht eine andere Variante vor, dass eine oder mehrere der zur räumlichen Kodierung im jeweiligen Teilvolumen zugewiesenen Magnetfeldausprägungen zur Frequenzkodierung verwendet werden. Dies erlaubt unter anderem die Verwendung von Standardsequenzen der zweidimensionalen Bildgebung, welche, zum Beispiel basierend auf einer radialen oder spiralen Kodierung, eine reine Frequenzkodierung verwenden.

Eine weitere alternative Variante sieht vor, dass eine oder mehrere der zur räumlichen Kodierung im jeweiligen Teilvolumen zugewiesenen Magnetfeldausprägungen zur Phasenkodierung verwendet werden. Dies erlaubt unter anderem die Verwendung von Standardsequenzen der zweidimensionalen Bildgebung wie zum Beispiel Chemical-Shift-Imaging (CSI) oder klassische Spektroskopiesequenzen, welche eine reine Phasenkodierung verwenden.

Im Rahmen der vorliegenden Erfindung fällt auch eine Variante des erfindungsgemäßen Verfahrens, die dadurch gekennzeichnet ist, dass die Form der verwendeten Feldkomponenten Kugelflächenfunktionen erster und höherer Ordnung entspricht. Die Form der Kugelflächenfunktionen erster Ordnung zeichnet sich hierbei durch einen räumlich linearen, die der höheren Ordnung durch einen räumlichen nicht-linearen Verlauf aus. Durch die lineare Kombination von Kugelflächenfunktionen unterschiedlicher Ordnung ergibt sich somit eine große Bandbreite an möglichen Feldverläufen, resultierend in einer hohen Flexibilität bei der Wahl der Schichtform. Diese Verwendungsvariante nutzt zusätzlich die Eigenschaft von Kugelflächenfunktionen aus, dass hier leicht Funktionen gefunden werden können, deren Gradienten global orthogonal zueinander stehen wie zum Beispiel für den Fall zylindersymmetrischer Funktionen. Folglich lassen sich für eine zur Schichtselektion gewählte erste Magnetfeldausprägung $B_{grad1}$ besonders einfach zwei weitere Linearkombinationen aus Kugelflächenfunktionen erster und höherer Ordnung berechnen, deren Gradienten global senkrecht zueinander und zu dem der ersten Magnetfeldausprägung $B_{grad1}$ stehen.

Eine vorteilhafte Weiterentwicklung dieser Variante sieht vor, dass die verwendeten Magnetfeldausprägungen die Form

- $B_{grad1}(x,y,z)=a_1{}^*x+b_1{}^*y+c_1{}^*z+d_1{}^*(x^2-y^2)+e_1{}^*(xy)$
- $B_{grad2}(x,y,z)=a_2{}^*x{\cdot}b_2{}^*y+c_2{}^*z+d_2{}^*(x^2-y^2)+e_2{}^*(xy)$
- $B_{grad3}(x,y,z)=a_3{}^*x+b_3{}^*y+c_3{}^*z$

haben, wobei $a_i$, $b_i$, $c_i$, $d_i$ und $e_i$ die Amplituden der jeweiligen Feldkomponenten beschreiben. Die einzelnen Magnetfeldausprägungen stellen somit eine Linearkombination aus den Kugelflächenfunktionen erster Ordnung und aus ausgewählten Kugelflächenfunktionen zweiter Ordnung dar. Im Vergleich zu Termen dritter oder höherer Ordnungen finden in dieser Variante des erfindungsgemäßen Verfahrens keine komplexen Zusatzterme wie beispielsweise $z{}^*(x^2-y^2)$ Verwendung. Der hieraus resultierende, schlichtere Feldverlauf der Magnetfeldausprägungen erlaubt daher eine besonders einfache Wahl der anzuregenden Schicht. So kann zum Beispiel die Schichtposition für einen gegebenen Frequenzoffset direkt über die Amplituden $a_1$, $b_1$ und $c_1$ variiert werden. Die Wahl dieser Feldkomponenten liegt ebenfalls sehr nahe, da sie entweder konventionellen linearen Gradienten oder Feldkomponenten des Shimsystems entsprechen und folglich ein Design, beziehungsweise Baupläne bereits vorhanden sind. Zusätzlich zeichnen sich die zugehörigen Feldkomponenten durch eine hohe energetische Effizienz aus, da die Stromanforderung mit der Höhe der Ordnung steigt. Die durch die erste Magnetfeldausprägung $B_{grad1}$ resultierende organische Schichtform entspricht zudem typischen Formen im menschlichen Körper.

Alternativ sieht eine andere Variante des erfindungsgemäßen Verfahrens vor, dass zur Erzeugung der $n_k$ ($n_k = n_{lin}$, + $n_{nonlin}$) einzelnen Feldkomponenten $n_g$ Spulenelemente zur Verfügung stehen, wobei die $n_k$ einzelnen Feldkomponenten als lineare Summe der Felder von jeweils $n_{gi}$ ($n_{gi}$ Element N, $n_{gi}$ <= ng) Spulenelementen gebildet werden. Dieses auch als Matrixverfahren bezeichnete Verfahren zeichnet sich durch eine besonders hohe Bandbreite an möglichen Feldformen und somit eine besonders hohe Flexibilität bei der Wahl der Schichtform aus. Die Verwendungsvariante erlaubt ebenfalls die auf einen ausgewählten Bereich beschränkte Erzeugung von Magnetfeldausprägungen. Dies resultiert nicht nur in einem reduzierten Energiebedarf, auch kann durch diese räumliche Begrenzung die globale Variation des Magnetfeldes minimiert werden. Letzteres ist wiederum mit der Reduzierung des PNS Risikos (PNS=Perihperal Nerve Stimulation) verbunden und erlaubt im Umkehrschluss eine entsprechende Erhöhung der Schaltrate der Magnetfeldausprägungen.

Die Bestimmung der individuellen Spulenelementströme erfolgt durch Vorgabe einer Ziel-Magnetfeldausprägung gemäß der Form der anzuregenden Schicht und anschließender Lösung des zugehörigen linearen Gleichungssystems mit Methoden wie z. B. der regularisierten Matrixinversion. Dieses Verfahren wird ebenfalls zur Erzeugung der weiteren Magnetfeldausprägungen $B_{gradi}$ (i>1) angewandt. Die Form der zugehörigen Ziel-Magnetfeldausprägungen ergibt sich hierbei wiederum aus dem annähernd erfüllten Orthogonalitätskriterium. Kann letzteres aus hardwaretechnischen Gründen nicht eingehalten werden, ist unter Umständen auch eine leichte Anpassung von $B_{grad1}$, und somit auch der Schichtform, notwendig.

Eine besonders bevorzugte Variante des erfindungsgemäßen Verfahrens ist dadurch gekennzeichnet, dass die Mittelfläche der jeweils selektierten Schicht eine Punktwolke aus Punkten $P_n$ einschließt (n Element N, n>= 4) mit $B_{grad1}(P_n)$ * y = Frequenzoffset +/-0,5 $BW_{HF-Puls}$. Durch Verwendung einer Schicht mit angepasster Position, Orientierung und Krümmung ist es somit möglich, Punktwolken innerhalb einer Schicht zu selektieren, für deren Selektion bei Verwendung konventioneller, linearer Gradienten und eine dickere Schicht verbunden mit einer zeitaufwändigen 3D Kodierung oder, bei vergleichbarer Schichtdicke, mehrere Schichten notwendig wären. Das erfindungsgemäße Verfahren stellt somit eine Effizienzsteigerung des gesamten Abbildungsprozesses dar, da weniger Volumen selektiert und ortskodiert werden muss. Auch entfällt eine Reformatierung der einzelnen Schichten. Ebenfalls ermöglicht es das erfindungsgemäße Verfahren, durch entsprechende Wahl der Punkte $P_n$ Artefaktquellen, wie sie zum Beispiel sich bewegende Bereiche darstellen, zu umgehen.

Eine Weiterentwicklung dieser Variante ist dadurch gekennzeichnet, dass die Punkte $P_n$ denjenigen Positionen im abzubildenden Bereich des zu untersuchenden Objekts entsprechen, welche zeitsynchron und in einem MR-Bild abgebildet werden sollen. Folglich ist eine direkte, zeitsynchrone Analyse der verschiedenen Positionen $P_n$ möglich. Dies ist besonders von Vorteil für die Analyse dynamischer Prozesse, wie beispielsweise in der fMRI (=funktionellen Magnetresonanzbildgebung). Befänden sich die zu analysierenden Aktivierungsgebiete in unterschiedlichen Schichten, wäre zuerst eine komplexe Zeitsynchronisation erforderlich, welche für manche Experimente gar nicht möglich ist.

Eine Alternative zu dieser Variante zeichnet sich dadurch aus, dass die Punkte $P_n$ denjenigen Positionen im abzubildenden Bereich des zu untersuchenden Objekts entsprechen, welche eine bevorzugte Ortskodierung auf Basis der unterschiedlichen Spulensensitivitäten erlauben.

Eine solche Anpassung der Schichtform an die Sensitivitätsverteilungen der unterschiedlichen Spulen resultiert in der maximierten Generierung von Unterschieden zwischen den empfangenen Signalen der einzelnen Empfangsspulen. Diese Maximierung der Zusatzinformationen erlaubt wiederum die Rekonstruktion von maximal unterabgetasteten Daten und somit eine Beschleunigung des Aufnahmeverfahrens.

Eine besondere Weiterentwicklung zu diesen alternativen Varianten zeichnet sich dadurch aus, dass die Punkte $P_n$ Orten des visuellen Cortex eines Lebewesens entsprechen und sich nach dem darüber liegenden Schädel richten. Dies erlaubt zum einem, verschiedene Aktivierungsgebiete des visuellen Cortex zeitsynchron zu analysieren. Zum anderen werden zur Abdeckung des gesamten visuellen Cortexes im Vergleich zum Standardverfahren weniger Schichten benötigt. Die daraus resultierende geringere Aufnahmezeit ermöglicht die Analyse des visuellen Cortexes mit einer höheren Zeitauflösung.

Alternative entsprechen die Punkte $P_n$ Orten des Motorcortex eines Lebewesens mit gleicher Orientierung zu einer anatomischen Landmarke. Ein Beispiel für letztere wäre der "Sulcus Centrales". Analog zur Abbildung des visuellen Cortexes erlaubt diese Verwendungsvariante, verschiedene Aktivierungsgebiete des Motorcordex zeitsynchron zu analysieren. Ebenfalls wird die Effizienz der Abdeckung erhöht und ergibt somit die Möglichkeit einer erhöhten Zeitauflösung.

Wiederum alternativ entsprechen die Punkte $P_n$ Orten des Spinalkanals eines Lebewesens. Die Anpassung der Schichtkrümmung an den Verlauf des Spinalkanals verbunden mit der entsprechenden Kodierung erlaubt es, diesen in einer Schicht darzustellen. Durch Hinzufügen mehrere Schichten oder einer 3D Kodierung kann ebenfalls der Spinalkanal mit höherer räumlicher Auflösung oder die gesamte Wirbelsäule achsengerecht dargestellt werden.

Eine andere alternative Weiterbildung zeichnet sich dadurch aus, dass die Punkte $P_n$ Orten der Gelenkstruktur eines Lebewesens entsprechen. Durch Anpassung der Schichtkrümmung an die Krümmung eines Gelenks oder gelenkinterne Strukturen verbunden mit der erfindungsgemäßen Ortskodierung kann dieses ebenfalls achsengerecht und mit maximaler lokaler Auflösung dargestellt werden. Durch die Flexibilität bei der Schichtwahl ist es auch möglich, das Gelenk in verschiedenen Positionen und so hinsichtlich unterschiedlicher Streckungen, beziehungsweise Beugungen zu untersuchen.

Erwähnenswert ist auch eine alternative Weiterbidung, die dadurch gekennzeichnet, dass die Punkte $P_n$ Orten der Knochenoberfläche eines Lebewesens entsprechen. So ist es mit dem erfindungsgemäßen Verfahren zum Beispiel durch geeignete Schichtwahl möglich, den gesamten Umfang eines Knochens oder eines Großteils davon auf einer Ebene abzubilden.

Eine andere alternative Weiterbildung zeichnet sich dadurch aus, dass die Punkte $P_n$ Orten des Kiefers eines Lebewesens entsprechen. Die Anpassung der Schichtform an einen Kiefer erlaubt es, den gesamten Kiefer in einer oder wenigen Schichten darzustellen. Dies ist vor allem von Vorteil bei Untersuchungen des Zahnfleisches oder von entzündlichen Veränderungen im Bereich der Zahnwurzeln. Bei der konventionellen Bildgebung mit linearen Gradienten wäre bereits die Selektion von mehreren Schichten, beziehungsweise eine zeitaufwändige 3D Kodierung notwendig. Hinzu kommt, dass im Falle eine Ortskodierung gemäß dem Standardverfahren, die Überlagerung von Bereichen auf Grund der Projektion auf eine Ebene eine Analyse der Aufnahme sehr stark erschweren würde. Auch werden durch die erfindungsgemäße Anpassung der Schichtform an den Kiefer Artefaktquellen, wie beispielsweise der sich bewegende Hals, vermieden.

Weitere Vorteile der Erfindung ergeben sich aus der Beschreibung und den Zeichnungen. Ebenso können die vorstehend genannten und die noch weiter ausgeführten Merkmale erfindungsgemäß jeweils einzeln für sich oder zu mehreren beliebigen Kombinationen Verwendung finden. Die gezeigten beschriebenen Ausführungsformen sind nicht als abschließende Aufzählung zu verstehen, sonder haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert.

Es zeigen:

Fig. 1    den Verlauf der Isolinien von vier unterschiedlichen Feldkomponenten in der x-y Ebene;

Fig. 2    den Verlauf der Isolinien der schrittweisen angepassten ersten Magnetfeldausprägung $B_{grad1}$ und den Querschnitt der resultierenden Schichtform in der x-y Ebene;

Fig. 3    Querschnitt einer gekrümmte Schicht und die resultierende Voxelform für zwei unterschiedliche Kodierfelder in der x-y Ebene;

Fig. 4    eine gekrümmte Schicht in der x-y Ebene mit gleicher Dicke;

Fig. 5    ein Sequenzdiagramm mit der Schaltung der Magnetfeldausprägungen und der zugehörigen Feldkomponenten.

Die vorliegende Erfindung betrifft eine Weiterentwicklung von Verfahren der bildgebenden Magnetresonanz, welche die Selektion und Kodierung von gekrümmten Schichten ermöglichen. Sie basiert auf der Verwendung von Kombinationen aus Feldkomponenten mit räumlich linearen und räumlich nicht-linearen Verläufen einerseits zur Selektion, andererseits aber auch zur Ortskodierung von nicht-planaren Schichten.

Das Anlegen einer Magnetfeldausprägung während der Einstrahlung eines eindimensionalen HF-Pulses erlaubt die Selektion eines Volumens dessen Form abhängig vom räumlichen Verlauf der Magnetfeldausprägung und den Frequenzeigenschaften des HF-Pulses ist. Im Standardfall dieses als Schichtselektion bezeichneten Prozesses mit einem räumlich linearen Verlauf der Magnetfeldausprägung entspricht die Form des angeregten Volumens einer planaren Schicht. Setzt sich die Magnetfeldausprägung aus orthogonalen Feldkomponenten zusammen, so kann durch entsprechende Amplitudenwahl die Orientierung der Schicht beliebig geändert werden. Die Ortskodierung mit weiteren Magnetfeldausprägungen, deren Gradienten zueinander und zur Normalen der Mittelfläche der Schicht orthogonal ausgerichtet sind, resultiert in einer eindeutigen Abbildung der Schicht und einer rechtwinkligen Voxelform. Dies bedeutet, dass unterschiedliche Bereiche nicht auf denselben Ort abgebildet werden, auch ist die lokale Auflösung bedingt durch die Voxelform maximiert. Da alle Kodiergradienten parallel zur Mittelfläche der selektierten Schicht verlaufen, wird eine zusätzliche Signaldephasierung innerhalb der Schicht, wie im Falle nicht-paralleler Komponenten, vermieden.

Weißt die zur Selektion angewandte Magnetfeldausprägung einen räumlich-nicht linearen Verlauf auf, so weicht die Form des selektierten Volumens von dem einer planaren Schicht ab. Im Falle einer Zusammensetzung der Magnetfeldausprägung aus orthogonalen Feldkomponenten ist auch hier eine Rotation des Volumens möglich, eine zusätzliche Verwendung von linearen Feldkomponenten erlaubt zudem eine Positionsänderung des Volumens. Ein solches Verfahren ist beispielsweise aus [1] bekannt.

Eine Alternative zur Schichtselektion mittels eindimensionalen HF-Pulsen ist die Verwendung mehrdimensionaler Pulse. Wie aus [13] bekannt, erlaubt dieses Verfahren auch die Anregung von gekrümmten Schichten, wobei die Form, Orientierung und Position der Schicht mit sehr hoher Flexibilität gewählt werden kann und somit eine Anpassung an die Struktur des zu untersuchenden Objektes prinzipiell möglich ist. Eine Selektion mittels mehrdimensionaler HF-Pulse ist jedoch deutlich komplexer als mit konventionellen, eindimensionalen Pulsen. Die auf Grund von Relaxationsprozessen nur begrenzt zur Verfügung stehende Dauer für die Pulseinstrahlung limitiert besonders die Auflösung des zu selektierenden Volumens. Hinzu kommt das Risiko einer hohen Energiedeposition im zu untersuchenden Objekt, so dass die Anwendbarkeit in der Praxis stark eigeschränkt ist.

Gemäß dem Stand der Technik ist die Ortskodierung einer gekrümmten Schicht ebenfalls problematisch. Eine Kodierung mit konventionellen linearen Gradienten führt in den Bereichen, in denen die Gradienten nicht orthogonal zur Normalen der Mittelfläche ausgerichtet sind, zu verzerrten Voxeln verbunden mit einer reduzierten lokalen Auflösung und einer zusätzlichen Signaldephasierung. Abhängig von der Stärke der Krümmung ist ebenfalls eine mehrdeutige Abbildung möglich. Aus [13] ist ebenfalls ein spezielles Verfahren zur HF-Kodierung einer gekrümmten Schicht bekannt. Da dies ebenfalls auf mehrdimensionalen Pulsen basiert, bleibt die damit verbundene Problematik erhalten. Zudem erlaubt das Verfahren zwar die Vermeidung einer mehrdeutigen Abbildung, die Reduzierung der lokalen Auflösung bleibt jedoch auf Grund einer fehlenden Ausrichtung der resultierenden Voxel entlang der Mittelfläche der gekrümmten Schicht erhalten. Eine Ortskodierung mit linearen Gradienten unterschiedlicher Orientierung wie in [15] beschrieben, erlaubt in der Praxis ebenfalls nur eine grobe Annäherung an eine Kodierung entlang der Mittelfläche der gekrümmten Schicht.

Das erfindungsgemäße Verfahren basiert auf der Selektion von gekrümmten Schichten durch Anwendung einer Magnetfeldausprägung mit einem räumlich nicht-linearen Verlauf während der Einstrahlung eines eindimensionalen HF-Puls und der anschließenden Ortskodierung mittels Magnetfeldausprägungen, welche annähernd senkrecht zueinander und zur Normalen der Mittelfläche der gekrümmten Schicht ausgerichtet sind. An Hand des folgenden Ausführungsbeispiels wird das erfindungsgemäße Verfahren für den Fall, dass sich das angeregte Schichtvolumen aus $n_V=1$ Teilvolumen zusammensetzt und der räumliche Verlauf der verwendeten Feldkomponenten Kugelflächenfunktionen erster und zweiter Ordnung entspricht, beschrieben.

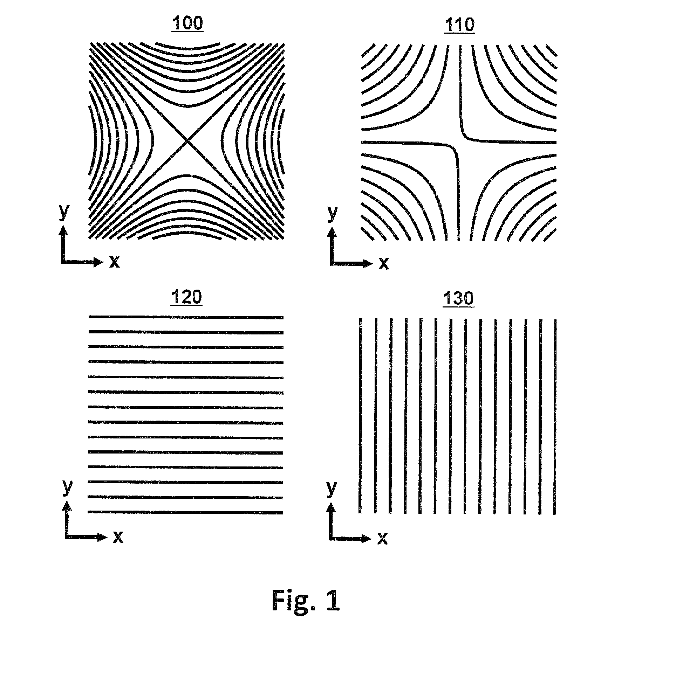

Fig. 1 zeigt den Verlauf der Linien gleicher Magnetfeldstärke (Isolinien) in der x-y Ebene von vier der fünf im Rahmen des Ausführungsbeispiels verwendeten Feldkomponenten. Die Isolinien der Feldkomponente **100** ($B(x,y,z)=x^2-y^2$) verlaufen global senkrecht zu denen der Komponente **110** ($B(x,y,z)=2xy$). Beide entsprechen Kugelflächenfunktionen 2. Ordnung und sind unveränderlich entlang der z Dimension. Ihre nicht-linearen Gradienten stehen ebenfalls global senkrecht zueinander. Die Feldkomponenten **120** ($B(x,y,z)=y$) und 130 ($B(x,y,z)=x$) zeichnen sich zusammen mit der nicht gezeigten Komponente $B(x,y,z)=z$ ebenfalls durch globale Orthogonalität aus. Diese drei Feldkomponenten erster Ordnung entsprechen den linearen Gradienten konventioneller Ortskodierung.

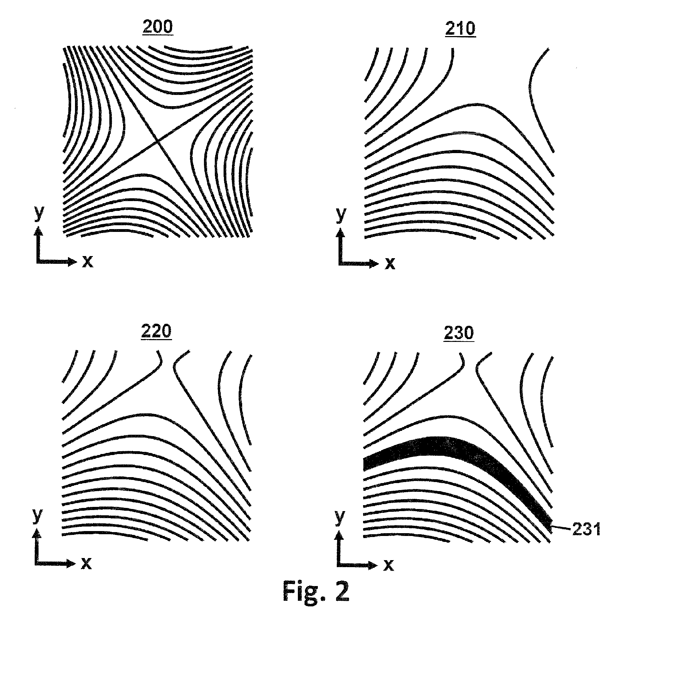

Fig. 2 zeigt eine erste Magnetfeldausprägung $B_{grad1}$ **200**, welche sich aus den beiden orthogonalen Feldkomponenten **100** und **110** zusammensetzt. Der Feldverlauf entspricht einer Rotation der Feldkomponenten **100** in der x-y Ebene um den Ursprung. Der Rotationswinkel wird über das Amplitudenverhältnis der beiden Feldkomponenten bestimmt. Addition der linearen Feldkomponente **120** resultiert in einer Verschiebung des Feldes in y-Richtung **(210)**, zusätzliche Addition der orthogonalen linearen Komponente **130** in x-Richtung **(220)**. Über das Amplitudenverhältnis aller vier Feldkomponenten kann somit das quadrupolare Feld sowohl beliebig rotiert als auch in der x-y Ebene verschoben werden. Wird die resultierende erste Magnetfeldausprägung $B_{grad1}$ **220** während der Einstrahlung eines HF-Pulses angelegt **(230)**, so wird die Wechselwirkung mit den Spins auf den selektierten Bereich **231** begrenzt. Die Position der Schicht ist hierbei gemäß Gleichung (2) durch den Frequenzoffset, die Schichtdicke durch die Bandbreite des Pulses gegeben. Für die in diesem Ausführungsbeispiel gegebenen erste Magnetfeldausprägung $B_{grad1}$ nimmt die Schichtkrümmung zu, je näher die die Schicht am Mittelpunkt der quadrupolaren Feldausprägung platziert ist. Eine Änderung der Schichtkrümmung für eine feste Position im Ortsraum wird daher durch eine Verschiebung des quadrupolaren Feldes und entsprechender Anpassung des Frequenzoffsets realisiert. Der selektierte Bereich **231** stellt hierbei lediglich einen Querschnitt der gekrümmten Schicht dar, welche konstant in z Richtung verläuft. Eine Einbeziehung der linearen Feldkomponente B(x,y,z)=z bei der Erzeugung der ersten Magnetfeldausprägung $B_{grad1}$, würde in diesem Fall eine zusätzliche Neigung der selektierten Schicht entlang der z-Achse erlauben.

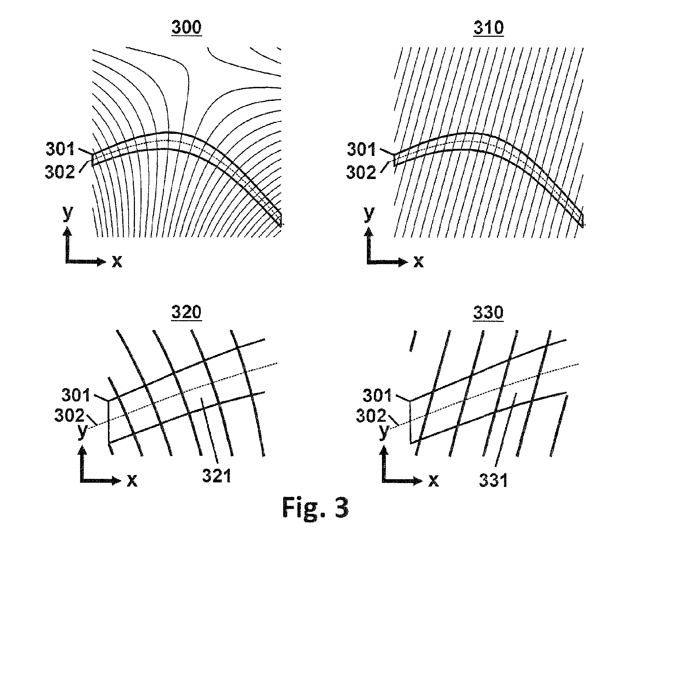

Entsprechend dem erfindungsgemäßen Verfahren erfolgt die Ortskodierung mit Magnetfeldausprägungen, deren Gradienten senkrecht zueinander und zu der Normalen der Mittelfläche ausgerichtet sind. Der Feldverlauf der dem Ausführungsbeispiel zugehörigen zweiten Magnetfeldausprägung $B_{grad2}$ **300** für die Kodierung entlang der gekrümmten Schichtdimension ist in **Fig. 3** gegeben. Er setzt sich aus den gleichen Feldkomponenten wie, jedoch mit einem anderen Amplitudenverhältnis als die erste Magnetfeldausprägung $B_{grad1}$ **220** zusammen. Die Kodierung entlang der zweiten Dimension erfolgt in diesem Fall mit dem linearen z-Gradienten. Ebenfalls eingezeichnet ist der Umfang **301** der selektierten Schicht, sowie der Verlauf der Mittelfläche 302. Im gesamten selektierten Bereich schneiden die Isolinien der zur Kodierung eingesetzten zweiten Magnetfeldausprägung $B_{grad2}$ **300** die Mittelfläche **302** senkrecht. Der zugehörige Feldgradient verläuft somit global entlang der Mittelfläche **302**, die Spindichte wird entsprechend senkrecht zur Mittelfläche projiziert. Der Verlauf der Schicht **301** und der Isolinien lassen ebenfalls Rückschlüsse auf die Voxelform ziehen. Wie in der Vergrößerung **320** des linken Teilbereiches ersichtlich, zeichnen sich alle Voxel durch eine rechtwinklige Form **321** aus. Ebenfalls sind alle Voxel entlang der Mittelfläche ausgerichtet. Die lokale Auflösung ist dadurch optimiert. Eine dem Stand der Technik entsprechende Kodierung mit einer konventionellen, linearen Magnetfeldausprägung **310,** würde trotz einer optimierten Ausrichtung in stark verzerrten Voxeln **331** resultieren, wie die Vergrößerung **330** zum Vergleich zeigt. Das Ausführungsbeispiel demonstriert somit, wie entsprechend dem erfindungsgemäßen Verfahren eine gekrümmte Schicht mit variabler Orientierung, Position und Krümmung selektiert und anschließend global entlang ihrer Mittelfläche kodiert werden kann.

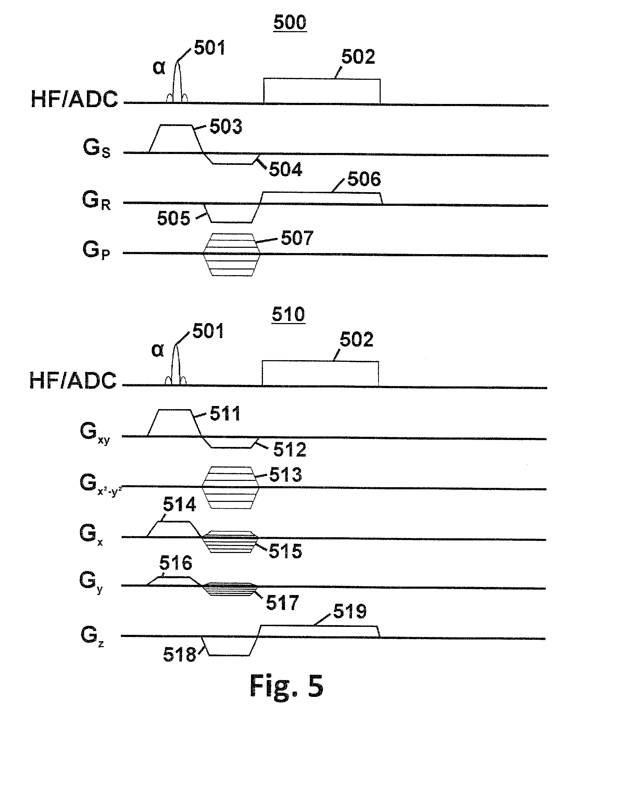

Für den besonderen Fall, dass das Volumen der selektierten Schicht sich aus nur $n_V$=1 Teilvolumen zusammensetzt, können die drei zur Selektion und Kodierung eingesetzten Magnetfeldausprägungen direkt einem Schichtselektions-, Phasenkodier- und Lesegradienten zugeordnet werden. Dies ermöglicht eine einfache Übertragung konventioneller Sequenzen inklusive ihrer zusätzlichen Gradienten wie beispielsweise Schichtrefokusierungs-, Spoiler- oder Dephasierungsgradienten auf das erfindungsgemäße Verfahren. In **Fig. 5** ist exemplarisch ein logisches Sequenzdiagramm **500** für eine Gradientenechosequenz (GE) gezeigt. Es beinhaltet die Amplitudenverläufe für den Schichtselektions- ($G_S$), Lese- ($G_R$) und Phasenkodiergradientenkanal ($G_P$), sowie die Schaltung des HF-Kanals und des ADCs (Analog-to-digital converter) zum Auslesen des MR-Signals. Während der Einstrahlung des HF-Pulses **510** mit Flipwinkel α wird der Schichtselektionsgradient **503** und anschließend der zugehörige Schichtrephasierungsgradient **504** geschalten. Die Rephasierung des MR-Signals erfolgt durch den Leserephasierungsgradienten **505.** Während des Auslesens des MR-Signals mittels des ADC **502** wird der Lesegradient **506** zur Ortskodierung entlang der nicht gekrümmten Schichtdimension geschalten. Die Ortskodierung entlang der gekrümmten Schichtdimension erfolgt mit dem Phasenkodiergradient **507.** Das physikalische Sequenzdiagramm **510** beschreibt den zugehörigen Amplitudenverlauf der einzelnen Feldkomponenten. In dem hier gezeigten Sequenzdiagrammbeispiel wird das quadrupolare Feld aus Gründen der Übersichtlichkeit nicht rotiert, sondern lediglich in x- und y-Richtung verschoben. Die dem logischen Schichtslektionsgradienten **503** zugeordnete Magnetfeldausprägung setzt sich in diesem Fall nur aus der nicht-linearen Feldkomponente **110** (B(x,y,z)=2xy) und den beiden linearen Komponenten **120** (B(x,y,z)=y) und **130** (B(x,y,z)=x) zusammen. Die Amplitude **511, 514** und **516,** mit welcher die einzelnen Feldkomponenten während des Schichtselektionsprozesses geschalten werden, ist durch die Amplitude des Schichtselektionsgradienten **503** und das die zugehörige Magnetfieldausprägung charakterisierende Amplitudenverhältnis gegeben. Die Bestimmung der Amplituden der einzelnen Feldkomponenten zur Schaltung des Schichtrephasierungs- **504** und Phasenkodiergradienten **507** erfolgt analog. Bedingt durch die zeitgleiche Schaltung beider logischer Gradienten kann dies zu Überlagerungen auf den physikalischen Kanälen führen. Die entsprechende Amplitude, mit welcher die Feldkomponente geschalten wird, ergibt sich aus der Summe der einzelnen Beiträge. In diesem Beispiel trifft das auf die Amplituden **515** und **517** der linearen Feldkomponenten zu, während für die Amplituden **512** und **513** der nicht-linearen Komponenten keine Überlagerung stattfindet. Die dem logischen Lesegradienten zugeordnete Magnetfeldausprägung setzt sich in diesem Beispiel nur aus der linearen Feldkomponenten (B(x,y,z)=z) zusammen. Die Amplituden **518** und **519** ergeben sich daher direkt aus den Amplituden **505** und **506.**

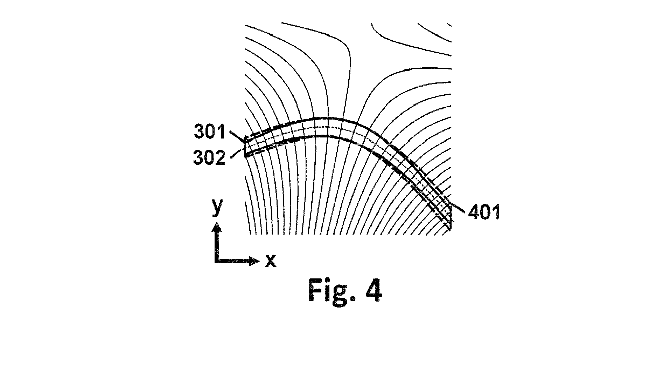

**Fig. 4** demonstriert eine Weiterbildung des erfindungsgemäßen Verfahrens, welche mehrdimensionale HF-Pulse zur Schichtselektion verwendet. Im Vergleich zur selektierten gekrümmten Schicht **301** bei Verwendung eines eindimensionalen Puls wird nun eine gekrümmte Schicht **401** mit gleichmäßiger Dicke aber gleicher Mittelfläche **302** selektiert. Entsprechend dem erfindungsgemäßen Verfahren erfolgt die Ortskodierung auch hier global entlang der gekrümmten Schicht, wie die senkrecht zur Mittelfläche **302** verlaufenden Isolinien der zur Kodierung eingesetzten Magnetfeldausprägung zeigen.

Referenzen

[1] C.-h. Oh and S. K. Hilal, "Method and apparatus for spatial localization of magnetic resonance signals," 1992.

[2] D. Gallichan, C. A. Cocosco, A. Dewdney, G. Schultz, A. Welz, J. Hennig, and M. Zaitsev, "Simultaneously driven linear and nonlinear spatial encoding fields in MRI," Magn Reson Med, vol. 65, pp. 702-714, Mar.

[3] J. L. Duerk, "Principles of MR image formation and reconstruction," Magn Reson Imaging Clin N Am, vol. 7, pp. 629-659, Nov 1999.

[4] D. J. Larkman and R. G. Nunes, "Parallel magnetic resonance imaging," Phys Med Biol, vol. 52, pp. R15-R55, Apr 2007.

[5] K. P. Pruessmann, M. Weiger, M. B. Scheidegger, and P. Boesiger, "SENSE: sensitivity encoding for fast MRI," Magn Reson Med, vol. 42, pp. 952-962, Nov 1999.

[6] K. P. Pruessmann, M. Weiger, M. B. Scheidegger, and P. Boesiger, "Magnetic resonance imaging method and apparatus," 2001.

[7] M. Griswold, "Magnetic resonance imaging method and apparatus employing partial parallel acquisition, wherein each coil produces a complete k-space datasheet," 2005.

[8] M. A. Griswold, P. M. Jakob, R. M. Heidemann, M. Nittka, V. Jellus, J. Wang, B. Kiefer, and A. Haase, "Generalized autocalibrating partially parallel acquisitions (GRAPPA)," Magn Reson Med, vol. 47, pp. 1202-1210, Jun 2002.

[9] S. Y. Lee and Z. H. Cho, "Localized volume selection technique using an additional radial gradient coil," Magn Reson Med, vol. 12, pp. 56-63, Oct 1989.

[10] C. H. Oh, S. K. Hilal, Z. H. Cho, and I. K. Mun, "New spatial localization method using pulsed high-order field gradients (SHOT: Selection with High-Order gradienT)," Magn Reson Med, vol. 18, pp. 63-70, Mar 1991.

[11] E. X. Wu, G. Johnson, S. K. Hilal, and Z. H. Cho, "A new 3D localization technique using quadratic field gradients," Magn Reson Med, vol. 32, pp. 242-245, Aug 1994.

[12] P. Börnert and T. Schäffter, "Curved slice imaging," Magn Reson Med, vol. 36, pp. 932-939, Dec 1996.

[13] P. Börnert, T. Schäffter, and H. Kuhn, "Verfahren und Gerät zur Bilderzeugung durch magnetische Resonanz eines gekrümmten Teils eines Körpers," 1997.

[14] P. Börnert, "2D-RF-pulse-encoded curved-slice imaging," Magn Reson Mater Phy, vol. 16, pp. 86-92, Jul 2003.

[15] T. H. Jochimsen and D. G. Norris, "Single-shot curved slice imaging," Magn Reson Mater Phy, vol. 14, pp. 50-55, Mar 2002.

**Patentansprüche**

1. Verfahren der bildgebenden MR (=Magnetresonanz),

 wobei mit Hilfe eines Gradientensystems ein räumlich und zeitlich veränderliches Magnetfeld $B_{grad}$ zur räumlichen Selektion eines abzubildenden Bereiches und zur mindestens zweidimensionalen Ortskodierung der MR-Signale im abzubildenden Bereich eines zu untersuchenden Objektes eingesetzt wird, wobei das Magnetfeld $B_{grad}$ $n_{lin}$ Feldkomponenten mit einem räumlich linearen, sowie $n_{nonlin}$ Feldkomponenten mit einem räumlich nicht-linearen Verlauf aufweist, wobei $n_{lin}+n_{nonlin} \geq 1$,

 wobei die Amplitude und der räumliche Verlauf von $B_{grad}$ über die Stärke und das Verhältnis der Amplituden der einzelnen Feldkomponenten gesteuert wird, wobei das Senden des oder der HF-(=Hochfrequenz-) Pulse über ein HF-Sendesystem mit $n_s$ Sendespulen erfolgt, mit $n_s \geq 1$,

 und wobei der Empfang des von dem zu untersuchenden Objekt gesendeten HF-Signals über ein HF-Empfangssystem mit $n_E$ Empfangsspulen erfolgt, mit $n_E \geq 1$ **dadurch gekennzeichnet,**

 **dass** das Magnetfeld $B_{grad}$ während eines einzelnen Messzyklus vom Anregen bis zum Auslesen der MR-Signale in wenigstens drei Magnetfeldausprägungen $B_{gradi}$ im abzubildenden Bereich des zu untersuchenden Objektes eingesetzt wird, dass die erste Magnetfeldausprägung $B_{grad1}$ einen räumlich nicht-linearen Verlauf hat

 **dass** durch Anlegen der ersten Magnetfeldausprägung $B_{grad1}$ während der Einstrahlung eines oder mehrerer HF-Pulse das Volumen mindestens einer gekrümmte Schicht selektiert wird,

 **dass** die Position und Orientierung der gekrümmten Schicht, der Grad der Krümmung und die Dicke der Schicht über die Amplitude und den räumlichen Verlauf der ersten Magnetfeldausprägung $B_{grad1}$ der Höhe des Frequenzoffsets und des zeitlichen Verlaufs des oder der HF-Pulse gewählt werden, wobei die Position, Orientierung und Krümmung der Schicht über ihre Mittelfläche AM mit $B_{grad1}(A_M)$= gyromagnetisches Verhältnis y*Frequenzoffset beschrieben wird und ihre Dicke über die jeweilige Ausdehnung der Schicht entlang der Normalen der Mittelfläche AM definiert ist,

 **dass** sich das Volumen der selektierten Schicht aus $n_V$ Teilvolumen zusammensetzt,

 **dass** in jedem Teilvolumen die Gradienten von mindestens einem Paar der übrigen Magnetfeldausprägungen $B_{gradi}$ (i>1) zueinander und zur Normalen der Mittelfläche AM innerhalb des Teilvolumens eine Winkelabhängigkeit von 70° bis 110° aufweisen, wobei mindestens eine Magnetfeldausprägung des jeweiligen Magnetfeldausprägungspaares einen räumlich nicht-linearen Verlauf aufweist, und **dass** Kombinationen dieser Paare zur mindestens zweidimensionalen Ortskodierung des MR-Signals entlang der Mittelfläche AM der selektierten Schicht verwendet werden.

2. Verfahren nach Anspruch 1, **dadurch gekennzeichnet, dass** unter Verwendung der ersten Magnetfeldausprägung $B_{grad1}$ eine zusätzliche Ortskodierung der selektierten Schicht jeweils entlang einer Achse, welche lokal im Bereich -20° bis 20° zur Normalen der Mittelfläche AM ausgerichtet ist, erfolgt.

3. Verfahren nach Anspruch 1 oder 2, **dadurch gekennzeichnet, dass** die erste Magnetfeldausprägung $B_{grad1}$ während der Einstrahlung des oder eines oder mehrerer der HF-Pulse zeitlich und räumlich variiert wird.

4. Verfahren nach einem der vorhergehenden Ansprüche, **dadurch gekennzeichnet, dass** die Magnetisierung der selektierten Schicht durch eine oder mehrere Anregungen, Refokusierungen und oder Sättigungen vorbereitet wird, wobei bei wenigstens einem HF-Puls die nicht-lineare erste Magnetfeldausprägung $B_{grad1}$ verwendet wird.

5. Verfahren nach einem der vorhergehenden Ansprüche, **dadurch gekennzeichnet, dass** der zeitliche Verlauf der Amplitude und Phase des oder eines oder mehrerer der HF-Pulse für jede der $n_s$ Sendespulen angepasst wird.

6. Verfahren nach einem der vorhergehenden Ansprüche, **dadurch gekennzeichnet, dass** während des Signalempfangs die lokale Gewichtung und Position der $n_e$ Empfangsspulen berücksichtigt wird und die Unterschiede zwischen den einzelnen Empfangsspulen für die Rekonstruktion des Bildes verwendet werden.

7. Verfahren nach einem der Ansprüche 1 bis 6, **dadurch gekennzeichnet, dass** eine der zur räumlichen Kodierung im jeweiligen Teilvolumen zugewiesenen Magnetfeldausprägungen zur Frequenzkodierung und eine andere zur Phasenkodierung verwendet werden.

8. Verfahren nach einem der Ansprüche 1 bis 6, **dadurch gekennzeichnet, dass** eine oder mehrere der zur räumlichen Kodierung im jeweiligen Teilvolumen zugewiesenen Magnetfeldausprägungen zur Frequenzkodierung verwendet werden.

9. Verfahren nach einem der Ansprüche 1 bis 6, **dadurch gekennzeichnet, dass** eine oder mehrere der zur räumlichen Kodierung im jeweiligen Teilvolumen zugewiesenen Magnetfeldausprägungen zur Phasenkodierung verwendet werden.

10. Verfahren nach einem der Ansprüche 1 bis 9, **dadurch gekennzeichnet, dass** die Form der verwendeten Feldkomponenten Kugelflächenfunktionen erster und höherer Ordnung entspricht.

11. Verfahren nach Anspruch 10, **dadurch gekennzeichnet, dass** die verwendeten Magnetfeldausprägungen die Form

- $B_{grad1}(x,y,z)=a_1*x+b_1*y+c_1*z+d_1*(x^2-y^2)+e_1*(xy)$
- $B_{grad2}(x,y,z)=a_2*x+b_2*y+c_2*z+d_2*(x^2-y^2)+e_2*(xy)$
- $B_{grad3}(x,y,z)=a_3*x+b_3*y+c_3*z$

haben, wobei $a_i$, $b_i$, $c_i$, $d_i$ und $e_i$ die Amplituden der jeweiligen Feldkomponenten beschreiben.

12. Verfahren nach einem der Ansprüche 1 bis 9, **dadurch gekennzeichnet, dass** zur Erzeugung der $n_k$ ($n_k = n_{lin} + n_{nonlin}$) einzelnen Feldkomponenten $n_g$ Spulenelemente zur Verfügung stehen, wobei die $n_k$ einzelnen Feldkomponenten als lineare Summe der Felder von jeweils $n_{gi}$ ($n_{gi}$ Element N, $n_{gi} <= ng$) Spulenelementen gebildet werden.

13. Verfahren nach einem der vorhergehenden Ansprüche, **dadurch gekennzeichnet, dass** die Mittelfläche der jeweils selektierten Schicht eine Punktwolke aus Punkten $P_n$ einschließt (n Element N, n>= 4) mit $B_{grad1}(P_n) * y$ = Frequenzoffset +/-0,5 $BW_{HF-Puls}$.

14. Verfahren nach Anspruch 13, **dadurch gekennzeichnet, dass** die Punkte $P_n$ denjenigen Positionen im abzubildenden Bereich des zu untersuchenden Objekts entsprechen, welche zeitsynchron und in einem MR-Bild abgebildet werden sollen.

15. Verfahren nach Anspruch 13, **dadurch gekennzeichnet, dass** die Punkte $P_n$ denjenigen Positionen im abzubildenden Bereich des zu untersuchenden Objekts entsprechen, welche eine bevorzugte Ortskodierung auf Basis der unterschiedlichen Empfangsspulensensitivitäten erlauben.

16. Verfahren nach Anspruch 13 oder 14 **dadurch gekennzeichnet, dass** die Punkte $P_n$ Orten des visuellen Cortex eines Lebewesens entsprechen und sich nach dem darüber liegenden Schädel richten.

17. Verfahren nach Anspruch 13 oder 14, **dadurch gekennzeichnet, dass** die Punkte $P_n$ Orten des Motorcortex eines Lebewesens mit gleicher Orientierung zu einer anatomischen Landmarke entsprechen.

**18.** Verfahren nach Anspruch 13 oder 14, **dadurch gekennzeichnet, dass** die Punkte $P_n$ Orten des Spinalkanals eines Lebewesens entsprechen.

**19.** Verfahren nach Anspruch 13 oder 14, **dadurch gekennzeichnet, dass** die Punkte $P_n$ Orten der Gelenkstruktur eines Lebewesens entsprechen.

**20.** Verfahren nach Anspruch 13 oder 14, **dadurch gekennzeichnet, dass** die Punkte $P_n$ Orten der Knochenoberfläche eines Lebewesens entsprechen.

**21.** Verfahren nach Anspruch 13 oder 14, **dadurch gekennzeichnet, dass** die Punkte $P_n$ Orten des Kiefers eines Lebewesens entsprechen.

100

110

120

130

Fig. 1

Fig. 2

Fig. 3

Fig. 4

**Fig. 5**

Europäisches
Patentamt

European
Patent Office

Office européen
des brevets

**EUROPÄISCHER RECHERCHENBERICHT**

Nummer der Anmeldung

EP 12 16 3177

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X,P | H WEBER ET AL: "ExLoc: Excitation and Encoding of Curved Slices", PROCEEDINGS OF THE INTERNATIONAL SOCIETY FOR MAGNETIC RESONANCE IN MEDICINE, 19TH ANNUAL MEETING AND EXHIBITION, MONTREAL, QUEBEC, 7-13 MAY 2011, 23. April 2011 (2011-04-23), Seite 2806, XP55032356, * das ganze Dokument * ----- | 1-21 | INV. G01R33/483 |
| A | WO 2007/061438 A2 (UNIV PENNSYLVANIA [US]; EPSTEIN CHARLES L [US]; MAGLAND JEREMY [US]) 31. Mai 2007 (2007-05-31) * das ganze Dokument * ----- | 1-21 | |
| A,D | GALLICHAN D., ET AL.: "Simultaneously driven linear and nonlinear spatial encoding fields in MRI", MAGN. RESON. MED., Bd. 65, 30. November 2010 (2010-11-30), Seiten 702-714, XP2656639, * das ganze Dokument * ----- | 1-21 | |
| A,D | BOERNERT P ET AL: "CURVED SLICE IMAGING", MAGNETIC RESONANCE IN MEDICINE, ACADEMIC PRESS, DULUTH, MN, US, Bd. 36, Nr. 6, 1. Dezember 1996 (1996-12-01), Seiten 932-939, XP000636875, ISSN: 0740-3194 * das ganze Dokument * ----- | 1-21 | RECHERCHIERTE SACHGEBIETE (IPC) G01R |
| A | WO 2010/068299 A1 (UNIV YALE [US]; CONSTABLE ROBERT TODD [US]; STOCKMANN JASON [US]; TAM) 17. Juni 2010 (2010-06-17) * das ganze Dokument * ----- -/-- | 1-21 | |

Der vorliegende Recherchenbericht wurde für alle Patentansprüche erstellt

| Recherchenort | Abschlußdatum der Recherche | Prüfer |
|---|---|---|
| München | 12. Juli 2012 | Streif, Jörg Ulrich |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Europäisches
Patentamt

European
Patent Office

Office européen
des brevets

## EUROPÄISCHER RECHERCHENBERICHT

Nummer der Anmeldung

EP 12 16 3177

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | US 5 122 748 A (OH CHANG-HYUN [US] ET AL) 16. Juni 1992 (1992-06-16) * das ganze Dokument * ----- | 1-21 | |
| A,D | WU E X ET AL: "A NEW 3D LOCALIZATION TECHNIQUE USING QUADRATIC FIELD GRADIENTS", MAGNETIC RESONANCE IN MEDICINE, ACADEMIC PRESS, DULUTH, MN, US, Bd. 32, Nr. 2, 1. August 1994 (1994-08-01) , Seiten 242-245, XP000458630, ISSN: 0740-3194 * das ganze Dokument * ----- | 1-21 | |
| A,D | OH C H ET AL: "NEW SPATIAL LOCALIZATION METHOD USING PULSED HIGH-ORDER FIELD GRADIENTS (SHOT: SELECTION WITH HIGH-ORDER GRADIENT)", MAGNETIC RESONANCE IN MEDICINE, ACADEMIC PRESS, DULUTH, MN, US, Bd. 18, Nr. 1, 1. März 1991 (1991-03-01), Seiten 63-70, XP000209830, ISSN: 0740-3194 * das ganze Dokument * ----- | 1-21 | RECHERCHIERTE SACHGEBIETE (IPC) |
| A,D | LEE S Y ET AL: "LOCALIZED VOLUME SELECTION TECHNIQUE USING AN ADDITIONAL RADIAL GRADIENT COIL", MAGNETIC RESONANCE IN MEDICINE, ACADEMIC PRESS, DULUTH, MN, US, Bd. 12, Nr. 1, 1. Oktober 1989 (1989-10-01), Seiten 56-63, XP000081155, ISSN: 0740-3194 * das ganze Dokument * ----- | 1-21 | |

Der vorliegende Recherchenbericht wurde für alle Patentansprüche erstellt

| Recherchenort | Abschlußdatum der Recherche | Prüfer |
|---|---|---|
| München | 12. Juli 2012 | Streif, Jörg Ulrich |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 12 16 3177

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-07-2012

| Im Recherchenbericht angeführtes Patentdokument | Datum der Veröffentlichung | Mitglied(er) der Patentfamilie | Datum der Veröffentlichung |
|---|---|---|---|
| WO 2007061438 A2 | 31-05-2007 | KEINE | |
| WO 2010068299 A1 | 17-06-2010 | US 2011241675 A1<br>WO 2010068299 A1 | 06-10-2011<br>17-06-2010 |
| US 5122748 A | 16-06-1992 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **C.-H. OH ; S. K. HILAL.** *Method and apparatus for spatial localization of magnetic resonance signals,* 1992
- **D. GALLICHAN ; C. A. COCOSCO ; A. DEWDNEY ; G. SCHULTZ ; A. WELZ ; J. HENNIG ; M. ZAITSEV.** Simultaneously driven linear and nonlinear spatial encoding fields in MRI. *Magn Reson Med,* vol. 65, 702-714
- **J. L. DUERK.** Principles of MR image formation and reconstruction. *Magn Reson Imaging Clin N Am,* November 1999, vol. 7, 629-659
- **D. J. LARKMAN ; R. G. NUNES.** Parallel magnetic resonance imaging. *Phys Med Biol,* April 2007, vol. 52, R15-R55
- **K. P. PRUESSMANN ; M. WEIGER ; M. B. SCHEIDEGGER ; P. BOESIGER.** SENSE: sensitivity encoding for fast MRI. *Magn Reson Med,* November 1999, vol. 42, 952-962
- **K. P. PRUESSMANN ; M. WEIGER ; M. B. SCHEIDEGGER ; P. BOESIGER.** *Magnetic resonance imaging method and apparatus,* 2001
- **M. GRISWOLD.** *Magnetic resonance imaging method and apparatus employing partial parallel acquisition, wherein each coil produces a complete k-space datasheet,* 2005
- **M. A. GRISWOLD ; P. M. JAKOB ; R. M. HEIDEMANN ; M. NITTKA ; V. JELLUS ; J. WANG ; B. KIEFER ; A. HAASE.** Generalized autocalibrating partially parallel acquisitions (GRAPPA. *Magn Reson Med,* Juni 2002, vol. 47, 1202-1210

- **S. Y. LEE ; Z. H. CHO.** Localized volume selection technique using an additional radial gradient coil. *Magn Reson Med,* Oktober 1989, vol. 12, 56-63
- **C. H. OH ; S. K. HILAL ; Z. H. CHO ; I. K. MUN.** New spatial localization method using pulsed high-order field gradients (SHOT: Selection with High-Order gradienT. *Magn Reson Med,* Marz 1991, vol. 18, 63-70
- **E. X. WU ; G. JOHNSON ; S. K. HILAL ; Z. H. CHO.** A new 3D localization technique using quadratic field gradients. *Magn Reson Med,* August 1994, vol. 32, 242-245
- **P. BÖRNERT ; T. SCHÄFFTER.** Curved slice imaging. *Magn Reson Med,* Dezember 1996, vol. 36, 932-939
- **P. BÖRNERT ; T. SCHÄFFTER ; H. KUHN.** *Verfahren und Gerät zur Bilderzeugung durch magnetische Resonanz eines gekrümmten Teils eines Körpers,* 1997
- **P. BÖRNERT.** 2D-RF-pulse-encoded curved-slice imaging. *Magn Reson Mater Phy,* Juli 2003, vol. 16, 86-92
- **T. H. JOCHIMSEN ; D. G. NORRIS.** Single-shot curved slice imaging. *Magn Reson Mater Phy,* Marz 2002, vol. 14, 50-55